# EUROPEAN PATENT APPLICATION

(11) **EP 4 800 454 A1**
(43) Date of publication of application: **02.09.2026**
(21) Application number: 26161302.0
(22) Date of filing: 27.02.2026
(51) Int. Cl.: G02B 6/43, G02B 6/12, G02B 6/42, G02B 6/35, H10W 70/00, H10W 90/10

(54) **GLASS OPTICAL INTERPOSER ASSEMBLY**

(30) Priority: 27.02.2025 US 202563764225 P; 20.03.2025 US 202563775238 P
(71) Applicant: Marvell Asia Pte Ltd, Singapore 369522 (SG)
(72) Inventor: Macian Ruiz, Carlos, Los Gatos, CA, 95032 (US); Allman, Sidney William, Stittsville, ON, K2S 1G9 (CA); Blacklow, Kazin Simon, Burlington, VT, 05401 (US); Baldwin, Zachary, Burlington, VT, 05401 (US); Zheng, Ting, San Jose, CA, 95126 (US); Chakravarti, Aatreya, Winooski, VT, 05404 (US); Gregory Jr., John Edward, Dummerston, VT, 05301 (US); Akiki, Samer, Redwood City, CA, 94063 (US); Sauter, Wolfgang, Starksboro, VT, 05487 (US); Kuemerle, Mark William, Essex Junction, VT, 05452 (US)
(74) Representative: Grünecker Patent- und Rechtsanwälte PartG mbB

(57) **Abstract**

A glass optical interposer assembly (11, 90) includes: (i) a glass pane (14) having one or more optical waveguides (16) embedded therein, (ii) a compute die (70) coupled to the glass pane (14), (iii) a plurality of high bandwidth memory (HBM) components (72) coupled to the glass pane (14) and arranged around the compute die (70), and (iv) a plurality of optical transceiver integrated circuits (22) embedded within the glass pane (14) and positioned at a depth having a Z dimension offset relative to respective ones of the compute die (70) and the plurality of HBM components (72), the one or more optical waveguides (16) provide optical communication pathways between the compute die (70) and the plurality of HBM components (72) through the plurality of optical transceiver integrated circuits (22).

## Description

### CROSS-REFERENCE TO RELATED APPLICATIONS

This application claims the benefit of U.S. Provisional Patent Application 63/764,225, filed February 27, 2025, and the benefit of U.S. Provisional Patent Application 63/775,238, filed March 20, 2025. The disclosures of these related applications are incorporated herein by reference.

### FIELD OF THE DISCLOSURE

The present disclosure relates generally to optical interconnect architectures for high-performance computing systems, and more particularly to glass-based optical interposers for interconnecting high bandwidth memory components with compute dies.

### BACKGROUND

Computing systems, particularly those designed for artificial intelligence workloads, increasingly rely on distributed architectures in which computational tasks are spread across multiple processing elements. As computational models grow in complexity and size, they often exceed the capacity of individual integrated circuits, necessitating the division of workloads across numerous chips that communicate with one another to function as a unified system.

The performance of such distributed computing systems depends substantially on the communication capabilities between the individual processing elements. Factors such as latency, throughput, power consumption, and signal integrity over distance all influence the overall system performance. When processing elements are physically separated, even by relatively short distances, these communication factors become increasingly relevant to system design considerations.

Various approaches exist for interconnecting multiple integrated circuits within computing systems. Copper-based die-to-die interfaces, including both serial and parallel implementations, provide electrical connectivity between adjacent dies. Co-packaged copper solutions bring cable connectors onto the package substrate to reduce signal path lengths. Optical interconnect approaches, including co-packaged optics and near-packaged optics, utilize fiber-attached modules to transmit signals between components using light rather than electrical signals.

Packaging technologies continue to evolve to address the demands of high-performance computing applications. Traditional package substrates are constructed from organic materials arranged in multiple layers around a central core. Glass-based materials have emerged as an alternative for certain packaging applications due to their physical properties, including planarity characteristics and dimensional stability.

Various communication technologies have been explored for interconnecting integrated circuits, with different approaches offering different tradeoffs in terms of signal propagation behavior over distance, power consumption profiles, and integration density. Additionally, thermal management remains a consideration in high-density computing systems where multiple processing elements generate heat in close proximity.

High Bandwidth Memory (HBM) has emerged as a memory interface technology for high-performance computing applications, such as machine learning accelerators and data center systems. HBM utilizes three-dimensional stacked memory dies connected through through-silicon vias (TSVs) to a buffer die containing a physical layer interface and controller circuitry. The buffer die communicates with compute dies such as application-specific integrated circuits (ASICs) or graphical processing units (GPUs) through electrical interconnects on an interposer.

However, conventional HBM implementations face limitations in scaling memory bandwidth and capacity. The number of HBM dies that can be positioned around a compute die is constrained by beachfront limitations at the die edges, throughput and signal integrity constraints of the electrical interface, and the inability to maintain performance when HBM dies are placed at diagonal positions or greater distances from the compute die. These constraints restrict the ability to add additional rows of HBM dies around compute elements, limiting the memory capacity and bandwidth available to high-performance computing systems.

The description above is presented as a general overview of related art in this field and should not be construed as an admission that any of the information it contains constitutes prior art against the present patent application.

### SUMMARY

An embodiment of the present invention that is described herein provides a glass optical interposer assembly, including: (i) a glass pane having one or more optical waveguides embedded therein, (ii) a compute die coupled to the glass pane, (iii) a plurality of high bandwidth memory (HBM) components coupled to the glass pane and arranged around the compute die, and (iv) a plurality of optical transceiver integrated circuits embedded within the glass pane and positioned at a depth having a Z dimension offset relative to respective ones of the compute die and the plurality of HBM components, the one or more optical waveguides provide optical communication pathways between the compute die and the plurality of HBM components through the plurality of optical transceiver integrated circuits.

In some embodiments, the compute die includes an application-specific integrated circuit (ASIC). In other embodiments, at least one of the plurality of HBM components is positioned at a diagonal position relative to the compute die. In yet other embodiments, the plurality of HBM components are arranged in multiple rows around the compute die.

In some embodiments, each of the plurality of HBM components includes a three-dimensional stack of memory dies connected through through-silicon vias to a buffer die. In other embodiments, the buffer die includes an electrical interface compatible with an optical engine. In yet other embodiments, the glass optical interposer further includes one or more optical engines positioned along edges of the glass pane to provide external connectivity to systems outside the glass optical interposer assembly.

In some embodiments, the glass optical interposer further includes additional HBM components positioned adjacent to the one or more optical engines along the edges of the glass pane, the additional HBM components are configured to exchange signals with the compute die through the one or more optical waveguides. In other embodiments, the one or more optical waveguides and the one or more optical engines are configured to provide optical communication pathways between the plurality of HBM components and external optical engines. In yet other embodiments, electrical interfaces of the compute die and the plurality of HBM components are positioned within interior regions of the respective dies and are not restricted to die edges.

In some embodiments, the glass optical interposer further includes circuit switching logic embedded within the glass pane and coupled to the one or more optical waveguides, and the circuit switching logic is configured to selectively route optical signals between the compute die and the plurality of HBM components. In other embodiments, the one or more optical waveguides are configured to provide constant latency optical communication pathways between the compute die and any of the plurality of HBM components regardless of physical positions of the HBM components on the glass pane.

In some embodiments, a first HBM component and a second HBM component, among the plurality of HBM components, are interconnected through the one or more optical waveguides. In other embodiments, the glass optical interposer further includes a printed circuit board configured to exchange signals with the glass pane, and the glass pane is positioned on the printed circuit board. In yet other embodiments, the one or more optical waveguides are configured to provide optical communication pathways between the compute die, the plurality of HBM components, and one or more optical engines, enabling communication with external systems.

There is additionally provided, in accordance with an embodiment of the present invention, a method for fabricating a glass optical interposer assembly, the method including receiving a glass pane having one or more optical waveguides and a plurality of optical transceiver integrated circuits embedded therein. A compute die is coupled to the glass pane. A plurality of high bandwidth memory (HBM) components are coupled to the glass pane, the plurality of HBM components arranged around the compute die. Optical communication pathways are established between the compute die and the plurality of HBM components through the one or more optical waveguides and the plurality of optical transceiver integrated circuits.

In some embodiments, the method further includes positioning at least one of the plurality of HBM components at a diagonal position relative to the compute die. In other embodiments, the method further includes arranging the plurality of HBM components in multiple rows around the compute die.

In some embodiments, the method further includes positioning one or more optical engines along edges of the glass pane to provide external connectivity to systems outside the glass optical interposer assembly. In other embodiments, coupling the plurality of HBM components includes replacing a physical layer interface of a HBM with an electrical interface compatible with an optical engine.

The present disclosure will be more fully understood from the following detailed description of the embodiments thereof, taken together with the drawings in which:

### BRIEF DESCRIPTION OF THE DRAWINGS

Fig. 1 is a cross-sectional view that schematically illustrates a glass optical interposer assembly, in accordance with an embodiment that is described herein;
Fig. 2 is a top-down view that schematically illustrates the glass optical interposer assembly of Fig. 1, in accordance with an embodiment that is described herein;
Fig. 3 is a top view that schematically illustrates the glass optical interposer assembly of Fig. 1 configured with an any-to-any optical crossbar topology, in accordance with an embodiment that is described herein;
Fig. 4 is a cross-sectional view that schematically illustrates the glass optical interposer assembly of Fig. 1, in accordance with an embodiment that is described herein;
Fig. 5 is a cross-sectional view that schematically illustrates a vertically tiled glass optical interposer assembly, in accordance with an alternative embodiment that is described herein;
Fig. 6 is a cross-sectional view that schematically illustrates a glass optical interposer assembly comprising a printed circuit board with a glass core, in accordance with an embodiment that is described herein;
Fig. 7 is an isometric view that schematically illustrates the glass optical interposer assembly of Fig. 1 incorporating micro-cooling channels, in accordance with another embodiment that is described herein;
Fig. 8 is a cross-sectional view that schematically illustrates a glass optical interposer assembly comprising an application-specific integrated circuit optically interconnected with high bandwidth memory components, in accordance with an embodiment that is described herein;
Fig. 9 is a top view that schematically illustrates a glass optical interposer assembly configured with a central application-specific integrated circuit surrounded by high bandwidth memory components and optical engines, in accordance with an embodiment that is described herein; and
Fig. 10 is a flowchart that schematically illustrates a method of interconnecting electrical integrated circuits, in accordance with an embodiment of the present disclosure.

### DETAILED DESCRIPTION OF EMBODIMENTS OVERVIEW

Modern computing systems, such as systems designed for artificial intelligence (AI) workloads, increasingly require the distribution of computational tasks across multiple processing elements. As AI models have grown in size and complexity, they often exceed the capacity of individual integrated circuits and must be divided into shards that are distributed across numerous accelerator chips or graphical processing units (GPUs). These distributed systems must nevertheless behave as unified computational entities, which places substantial demands on the communication infrastructure connecting the individual processing elements.

The performance of distributed computing systems is fundamentally constrained by the input/output capabilities between individual chips, including latency, throughput, power consumption, and signal integrity over distance. Conventional approaches to interconnecting multiple dies face significant challenges. Copper-based die-to-die interfaces, while providing electrical connectivity between adjacent dies, suffer from distance-dependent signal loss, beachfront limitations at die edges, and increasing power consumption as throughput requirements grow. Co-packaged copper and co-packaged optics solutions attenuate some distance and loss problems but introduce mechanical stress and reliability concerns associated with cable and fiber assemblies. Furthermore, approaches that attempt to place multiple dies on a common substrate encounter fabrication yield concerns that worsen as more elements are integrated, and face fundamental substrate size limitations that fall well below the dimensions of a typical board.

A particularly significant barrier exists between components that reside within the same package and those that must communicate across package boundaries. In-package communication can achieve relatively intense and streamlined data exchange, whereas cross-package communication typically incurs an order of magnitude increase in latency, power consumption, and complexity, along with reduced bandwidth. Existing optical interposer solutions, while addressing some distance and beachfront limitations, remain constrained to dimensions of a single semiconductor wafer (e.g., less than 210 mm) and carry yield penalties and cost concerns.

Embodiments of the present disclosure that are described herein address these challenges by providing a glass optical interposer architecture in which individually packaged electrical integrated circuits are assembled over a glass pane. In some embodiments, the glass pane is configured to contain embedded optical transceiver integrated circuits, one or more optical waveguides, and circuit switching logic. The glass pane serves as an optical interconnection medium configured to enable high-bandwidth, low-latency communication between the electrical integrated circuits through optical signal transmission rather than electrical signaling over copper traces.

In some embodiments, the optical waveguides embedded within the glass pane are arranged to provide an optical ring topology or a grid topology, which are configured to interconnect the plurality of electrical integrated circuits in a serial communication configuration. In other embodiments, the optical waveguides are arranged to provide an any-to-any optical crossbar topology that enables direct optical communication between any pair of electrical integrated circuits without requiring signals to traverse intermediate nodes. In an example implementation, the circuit switching logic embedded within the glass pane dynamically selects which optical waveguide to use based on the destination of a communication, enabling flexible and reconfigurable interconnect topologies.

In some embodiments, the disclosed glass optical interposer architecture enables optical interconnection between high bandwidth memory (HBM) components and compute dies such as application-specific integrated circuits (ASICs). By replacing conventional HBM physical layer interfaces with electrical interfaces compatible with optical engines, HBM dies and compute dies can be assembled on the glass pane and interconnected through the embedded optical waveguides. This configuration overcomes the beachfront limitations of conventional HBM implementations, allowing electrical interfaces to be positioned anywhere within the HBM and ASIC dies rather than being restricted to die edges.

In some embodiments, the optical interconnection through the glass pane enables placement of any number of HBM dies around a compute die at varying distances, such as diagonal positions and multiple rows of HBM dies that would be infeasible with conventional electrical interconnects. The embedded optical interfaces allow communication over significant distances without loss of performance or noticeable increase in latency, thereby greatly increasing memory capacity, bandwidth, and connectivity available to high-performance computing systems.

In some embodiments, the electrical integrated circuits are individually packaged on package substrates and assembled on a surface of the glass pane, with the glass pane itself mounted on a printed circuit board (PCB) for mechanical support and electrical connectivity. In some embodiments, the optical transceiver integrated circuits are three-dimensionally stacked with respective electrical integrated circuits, and the resulting stacked assemblies are embedded within the glass pane to reduce insertion loss between the electrical components and the optical components. In an example implementation, multiple glass panes with embedded components are vertically stacked and interconnected through one or more vertical waveguides to increase system density without increasing lateral distances between dies. In some embodiments, the glass pane is integrated as a core layer within a PCB rather than being mounted on top of a separate PCB. In some embodiments, micro-cooling channels are embedded within the glass pane to provide fluid cooling to the electrical integrated circuits assembled on the glass optical interposer.

The disclosed glass optical interposer architecture provides several advantages over conventional interconnect approaches. Optical signal propagation through the embedded waveguides is substantially insensitive to distance at the scale of centimeters, enabling constant latency communication between any pair of electrical integrated circuits regardless of their physical positions on the glass pane. The glass pane can be manufactured at sizes substantially larger than conventional interposers, enabling scalability up to board-level dimensions without the size constraints imposed by wafer-based fabrication. The architecture eliminates beachfront limitations because electrical interfaces can be positioned in the middle of dies rather than being constrained to die edges. The use of individually packaged known-good dies (KGDs) assembled on the glass pane improves overall yield compared to approaches that integrate multiple bare dies on a common substrate, where a single defective die can compromise the entire assembly. The elimination of fiber and cable assemblies removes associated mechanical stress and reliability concerns. Additionally, the physical properties of glass, such as the stiffness and planarity characteristics, help address warpage issues that arise in very large packages constructed from organic materials of traditional package substrates.

The description above is presented as a general overview of embodiments of the present disclosure, which are described in detail herein.

### DEFINITIONS

In the present context, the term "glass pane" may refer to a substrate layer constructed from glass-based material that serves as an optical interposer containing embedded optical components and waveguides for interconnecting integrated circuits. A glass pane may be positioned on a printed circuit board or integrated as a core layer within a printed circuit board. For example, a glass pane may contain embedded optical waveguides, circuit switching logic, and optical transceiver integrated circuits that collectively enable optical communication between electrical integrated circuits assembled on the glass pane.

In the present context, the term "optical waveguide" may refer to a structure embedded within a glass pane that guides optical signals along defined pathways to enable communication between components. An optical waveguide may be arranged in various topologies, such as but not limited to an optical ring topology, an optical grid topology or an any-to-any optical crossbar topology. For example, an optical waveguide may extend horizontally through a glass pane to provide an optical communication pathway between two optical transceiver integrated circuits, or a vertical waveguide may extend between stacked glass panes to enable inter-layer optical communication.

In the present context, the term "optical transceiver integrated circuit" may refer to an integrated circuit that performs conversion between electrical signals and optical signals for transmission through optical waveguides. An optical transceiver integrated circuit may comprise optical transmitters to convert electrical signals to optical signals and optical receivers to convert optical signals to electrical signals. For example, an optical transceiver integrated circuit may be embedded within a glass pane and electrically coupled to an electrical integrated circuit through an electro-optical interface.

In the present context, the term "circuit switching logic" may refer to circuitry embedded within a glass pane that enables selective routing of optical signals through optical waveguides based on communication destinations. Circuit switching logic may be configured to provide various interconnect topologies and may be dynamically adjusted during operation. For example, circuit switching logic may select which optical waveguide to use for a communication between two electrical integrated circuits based on the destination of the communication.

In the present context, the term "electrical integrated circuit" or "EIC" may refer to one or more integrated circuits containing one or more processing circuitries that communicates with other components through electrical signals. One or more electrical integrated circuits may be packaged individually or as a group on a package substrate and assembled on a glass pane. For example, an electrical integrated circuit may comprise an artificial intelligence accelerator chip, a tensor processing unit (TPU) or a graphical processing unit (GPU) that communicates with other electrical integrated circuits through optical communication pathways provided by optical waveguides embedded in a glass pane.

In the present context, the terms "optical ring topology" and "grid topology" may refer to an arrangement of optical waveguides in which electrical integrated circuits are interconnected in a serial communication configuration, or in a combined parallel and serial configuration, forming a ring-shaped communication pathway. For example, an optical ring topology may connect twelve electrical integrated circuits arranged in a grid pattern such that optical signals traverse the ring to reach destination circuits.

In the present context, the term "any-to-any optical crossbar topology" may refer to an arrangement of optical waveguides that enables direct optical communication between any pair of electrical integrated circuits without requiring signals to traverse intermediate nodes. An any-to-any optical crossbar topology provides constant latency communication regardless of the physical positions of communicating circuits. For example, an any-to-any optical crossbar topology may enable a first electrical integrated circuit to communicate directly with a twelfth electrical integrated circuit positioned at an opposite corner of a glass pane.

In the present context, the term "package substrate" may refer to a substrate structure that supports and provides electrical connections for one or more dies within an individually packaged electrical integrated circuit. A package substrate may be assembled on a surface of a glass pane. For example, a package substrate may support an electrical integrated circuit die and comprise terminals for electrical connection to optical transceiver integrated circuits embedded within a glass pane.

In the present context, the term "printed circuit board" or "PCB" may refer to a board that provides mechanical support and electrical connectivity for a glass optical interposer assembly. A printed circuit board may have a glass pane assembled on its surface or may have a glass pane integrated as a core layer within the printed circuit board. For example, a printed circuit board may support a glass pane containing embedded optical waveguides and provide external electrical connections for the glass optical interposer assembly.

In the present context, the term "micro-cooling channel" may refer to a conduit or pipe embedded within a glass pane through which fluid flows to provide cooling to components of a glass optical interposer assembly. Micro-cooling channels enable liquid cooling of electrical integrated circuits assembled on the glass pane. For example, micro-cooling channels may extend through a glass pane with fluid entering from one side and exiting from an opposite side (or another side) to dissipate heat generated by electronic integrated circuits.

In the present context, the term "vertical waveguide" may refer to an optical waveguide that extends between two or more stacked glass panes to provide optical interconnection between components on different layers of a vertically tiled glass optical interposer assembly. For example, a vertical waveguide may connect a first glass pane to a second glass pane stacked over the first glass pane, enabling optical communication between electrical integrated circuits embedded in different glass pane layers.

In the present context, the term "electro-optical interface" may refer to a component that provides the interface between electrical and optical domains, facilitating signal conversion between electrical integrated circuits and optical transceiver integrated circuits. For example, an electro-optical interface may be positioned between a package substrate and a glass pane to enable communication between an electrical integrated circuit and an optical waveguide embedded within the glass pane.

In the present context, the term "optical input/output" or "optical IO" may refer to a component within an optical transceiver integrated circuit that facilitates the coupling of optical signals between an optical waveguide and other optical components. For example, optical IO components may transmit optical signals into an optical waveguide and receive optical signals from the optical waveguide for conversion to electrical signals.

In the present context, the term "electrical input/output" or "electrical IO" may refer to a component on an electrical integrated circuit that provides electrical signal interfaces for communication with other components. For example, electrical IO components may transmit electrical signals to an electro-optical interface for conversion to optical signals and receive electrical signals converted from optical signals.

Here is a definition for "insertion loss" in the context of the present disclosure:
In the present context, the term "insertion loss" may refer to the reduction in signal power that occurs when a signal is transmitted between an electrical integrated circuit and an optical transceiver integrated circuit. Insertion loss is influenced by the signal path length and the number of interfaces between components. For example, three-dimensionally stacking an electrical integrated circuit on top of an optical transceiver integrated circuit and embedding the stacked assembly within a glass pane reduces insertion loss compared to configurations in which the electrical integrated circuit is mounted on a surface of the glass pane with a package substrate interposed between the electrical integrated circuit and the optical transceiver integrated circuit.

In the present context, the term "three-dimensionally stacked" may refer to a configuration in which an electrical integrated circuit is assembled on top of an optical transceiver integrated circuit, with the resulting stacked assembly embedded within a glass pane. Three-dimensional stacking reduces insertion loss between electrical and optical components. For example, an electrical integrated circuit may be three-dimensionally stacked over an optical transceiver integrated circuit, and the stacked assembly may be embedded within a glass pane to improve power efficiency of the optical communication pathway.

In the present context, the term "known-good die" or "KGD" may refer to an integrated circuit die that has been tested and verified to be functional prior to assembly into a larger system. The use of known-good dies improves overall yield of a glass optical interposer assembly. For example, individually packaged known-good dies may be assembled on a glass pane, such that a defective die can be identified and excluded before assembly rather than compromising an entire multi-die assembly.

In the present context, the term "high bandwidth memory" or "HBM" may refer to a memory interface technology utilizing three-dimensional stacked memory dies, such as but not limited to Dynamic Random Access Memory (DRAM) dies or Non-Volatile memory (NVM) dies, connected through through-silicon vias to a buffer die. The buffer die may contain a physical layer interface and controller circuitry for communication with compute dies. For example, high bandwidth memory components may be assembled on a glass pane and optically interconnected with application-specific integrated circuits through optical waveguides embedded within the glass pane.

In the present context, the term "beachfront limitation" may refer to a constraint on the number of components that can be directly connected to a die based on the available perimeter or edge space of the die. Beachfront limitations restrict the positioning of interfaces to die edges, which limits the number of memory components that can be placed around a compute die. For example, conventional high bandwidth memory implementations face beachfront limitations that restrict the number of HBM dies that can be positioned around a compute die, whereas optical interconnection through a glass pane overcomes beachfront limitations by allowing electrical interfaces to be positioned anywhere within the dies rather than being restricted to die edges.

In the present context, the term "optical engine" may refer to a component that provides optical transceiver functionality for converting between electrical signals and optical signals. An optical engine may be positioned at edges or corners of a glass pane to provide external connectivity to systems outside the glass optical interposer assembly. For example, optical engines may connect to electrical integrated circuits through optical waveguides embedded within a glass pane and provide communication pathways to other glass optical interposer assemblies, network interfaces, or storage systems.

In the present context, the term "compute die" may refer to an integrated circuit die that performs computational operations, such as an application-specific integrated circuit (ASIC), a graphical processing unit (GPU), or an artificial intelligence accelerator. A compute die may be assembled on or embedded within a glass pane and optically interconnected with high bandwidth memory components through optical waveguides embedded within the glass pane. For example, a compute die may communicate with multiple high bandwidth memory dies positioned at varying distances through optical communication pathways that provide constant latency regardless of physical separation.

### SYSTEM DESCRIPTION

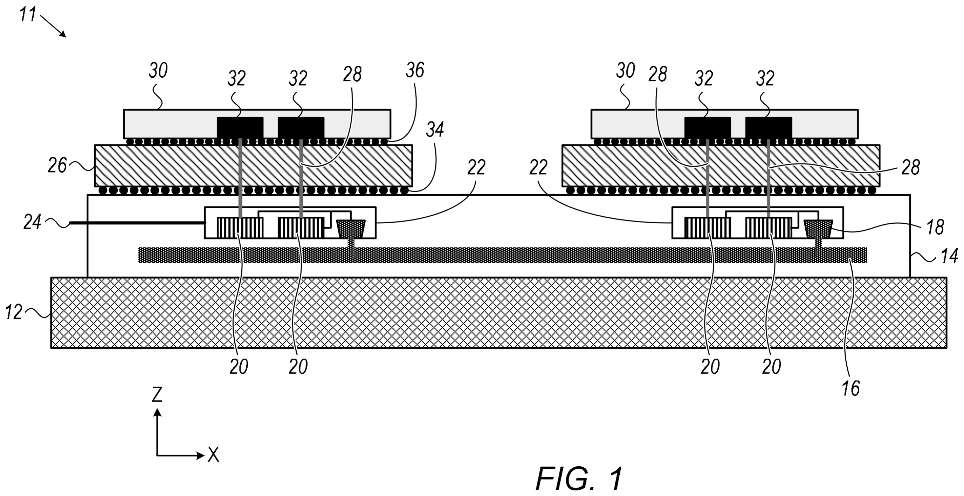

Fig. 1 is a cross-sectional view that schematically illustrates a glass optical interposer assembly 11, in accordance with an embodiment that is described herein. In the context of the present disclosure, glass optical interposer assembly 11 serves as a computing system, and is therefore also referred to herein as system.

In some embodiments, glass optical interposer assembly 11 comprises a Printed Circuit Board (PCB) 12, which provides mechanical support and electrical connectivity for the system. A glass pane 14 is positioned on PCB 12 and serves as an optical interposer substrate containing embedded optical components and waveguides described herein. Glass pane 14 provides planarity and reduced warpage (compared to an organic package substrate) due to the stiffness of glass, which enables the assembly of multiple individually packaged electrical integrated circuits without the mechanical distortion issues associated with the organic package substrate of a traditional interposer.

In some embodiments, glass pane 14 comprises one or more optical waveguides 16 embedded within glass pane 14. Optical waveguide 16 provides optical communication pathways between different portions of glass optical interposer assembly 11. A circuit switch 18 is embedded within glass pane 14 and coupled to optical waveguide 16. Circuit switch 18 enables selective routing of optical signals through optical waveguide 16, functioning as circuit switching logic configured to direct optical communications between components based on destination addresses.

In some embodiments, glass pane 14 further comprises an optical Input/Output (IO) 20, positioned within glass pane 14 to facilitate the coupling of optical signals between optical waveguide 16 and other optical components. In the present example, optical IOs 20 may comprise suitable type silicon photonics components. In some embodiments, an optical integrated circuit (OIC) 22 is embedded within glass pane 14. Optical integrated circuit 22 functions as an optical transceiver integrated circuit that comprises optical transmitters to convert electrical signals from electrical integrated circuits to optical signals, and optical receivers to convert optical signals from optical waveguide 16 to electrical signals for the electrical integrated circuits. A light source 24 is embedded within glass pane 14 to generate optical signals for transmission through optical waveguide 16.

In some embodiments, glass optical interposer assembly 11 further comprises a package substrate 26 positioned on glass pane 14. Package substrate 26 supports at least one integrated circuit (IC) die and provides electrical connections between the IC die and the optical components embedded within glass pane 14. An electro-optical interface 28 is positioned on package substrate 26 and provides the interface between electrical domains and optical domains, facilitating signal conversion between an electrical integrated circuits (EICs) 30 and optical integrated circuit (OICs) 22.

In some embodiments, at least an EIC 30 is mounted on package substrate 26. Electrical integrated circuit 30 contains processing circuitry and communicates with other electrical integrated circuits 30 through the optical communication pathways provided by optical waveguide 16 and optical integrated circuit 22. In some embodiments, electrical integrated circuit 30 comprises a known good die (KGD) that has been individually tested before assembly on glass pane 14, which improves overall yield of glass optical interposer assembly 11 compared to approaches that integrate multiple untested bare dies on a common substrate.

In some embodiments, glass optical interposer assembly 11 comprises an electrical IO 32, which is positioned on or integrated within electrical integrated circuit 30 to provide electrical signal interfaces for communication with electro-optical interface 28. In some embodiments, glass optical interposer assembly 11 comprises terminals 34 and terminals 36, which may comprise bumps, micro-bumps, pins, hybrid bonding, or any other suitable electrical connections. Terminals 34 are disposed between package substrate 26 and glass pane 14 and are configured to provide electrical connections between electro-optical interface 28 and optical integrated circuit 22 embedded in glass pane 14. Terminals 36 are disposed between package substrate 26 and EIC 30 and are configured to provide electrical connections between package substrate 26 and EIC 30. In such embodiments, terminals 34 and 36 enable power and signal distribution throughout glass optical interposer assembly 11.

In some embodiments, the configuration shown in Fig. 1 depicts a plurality of individually packaged electrical integrated circuits 30 assembled on an outer surface of glass pane 14, with each electrical integrated circuit 30 coupled to glass pane 14 through a respective package substrate 26. Optical waveguide 16 is configured to provide optical communication pathways between the plurality of electrical integrated circuits 30 through the plurality of optical transceiver integrated circuits, represented by optical integrated circuit 22, and circuit switch 18. The optical communication pathways are configured to provide constant latency between any pair of electrical integrated circuits 30 regardless of physical distance on glass pane 14, because optical signal propagation through optical waveguide 16 is substantially insensitive to distance at the scale of centimeters typical of glass optical interposer assembly 11.

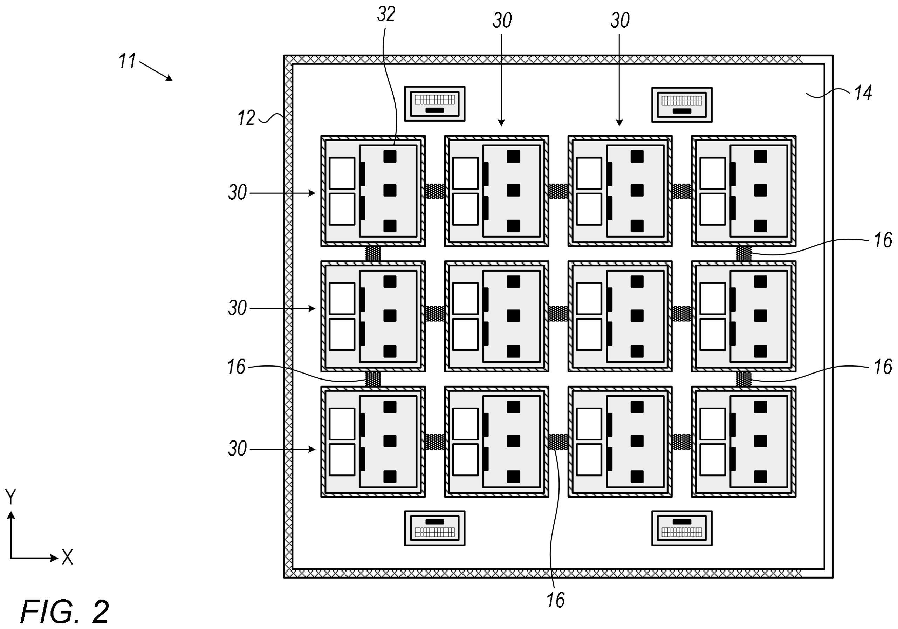

Fig. 2 is a top view that schematically illustrates glass optical interposer assembly 11, in accordance with an embodiment that is described herein.

In some embodiments, as described in Fig. 1 above, glass optical interposer assembly 11 comprises PCB 12, glass pane 14 assembled on a surface of PCB 12, and a plurality of electrical integrated circuits 30 positioned on glass pane 14.

In the example embodiments illustrated in Fig. 2, electrical integrated circuits 30 are organized in a three-by-four array, with each electrical integrated circuit 30 mounted on a respective package substrate 26, as described in detail in Fig. 1 above. In some embodiments, optical waveguides 16 are positioned between and around electrical integrated circuits 30, extending in both horizontal directions (e.g., along the X-axis and the Y-axis) across glass pane 14, thereby facilitating communication between electrical integrated circuits 30 positioned at various locations on glass pane 14.

In some embodiments, the arrangement of optical waveguides 16 within glass pane 14 enables flexible interconnect topologies between electrical integrated circuits 30. The physical grid layout of electrical integrated circuits 30 combined with optical waveguides 16 allows for configurable communication patterns. In some embodiments, the communication patterns comprise ring topologies in which electrical integrated circuits 30 are interconnected in a serial communication (or combined serial and parallel communication) configuration. In other embodiments, the communication patterns comprise any-to-any crossbar configurations in which direct optical communication is enabled between any pair of electrical integrated circuits 30, as described in more detail below. As described in Fig. 1 above. Moreover, glass pane 14 may be sized up to the dimensions of PCB 12, or to any other suitable dimensions, enabling interconnection of a larger number of electrical integrated circuits 30 than possible with wafer-sized interposers.

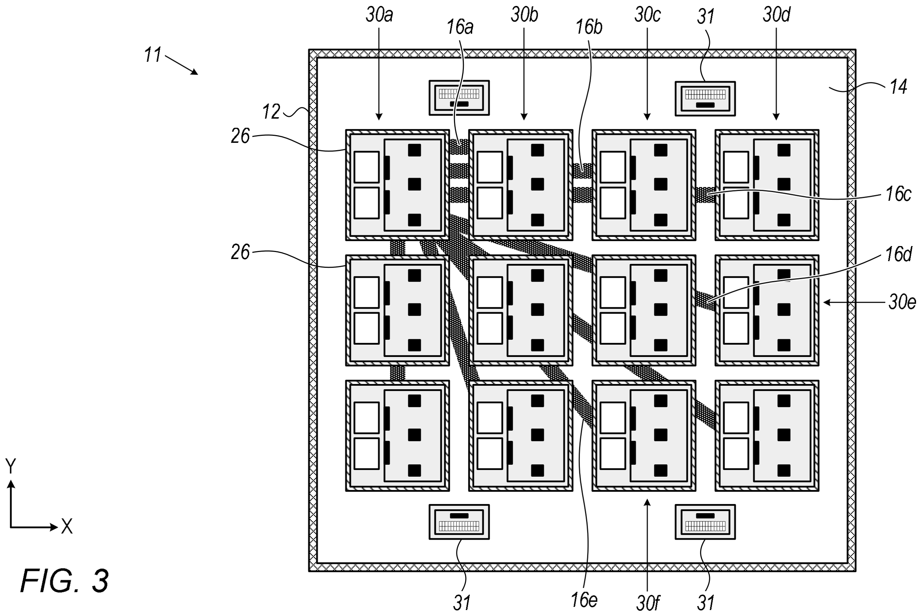

Fig. 3 is a top view that schematically illustrates glass optical interposer assembly 11 configured with an any-to-any optical crossbar topology, in accordance with another embodiment that is described herein.

In some embodiments, glass optical interposer assembly 11 comprises PCB 12 and glass pane 14 positioned on PCB 12, as described in detail in Fig. 1 above. Glass pane 14 contains embedded optical waveguides and circuit switching logic for routing optical signals between electrical integrated circuits, as described in detail below.

In some embodiments, glass optical interposer assembly 11 comprises a plurality of individually packaged electrical integrated circuits arranged in a grid pattern on glass pane 14. The plurality of electrical integrated circuits comprises an electrical integrated circuit 30a, an electrical integrated circuit 30b, an electrical integrated circuit 30c, an electrical integrated circuit 30d, an electrical integrated circuit 30e, and an electrical integrated circuit 30f, among others arranged in a three-by-four array. Each of electrical integrated circuits 30a, 30b, 30c, 30d, 30e, and 30f is mounted on a respective package substrate 26, as described in detail in Fig. 1 above.

In some embodiments, glass pane 14 contains multiple optical waveguides that provide optical communication pathways between the electrical integrated circuits. In some embodiments, an optical waveguide 16a and an optical waveguide 16b may be positioned near a top portion of glass pane 14, providing connectivity to an upper row of electrical integrated circuits. Additionally, an optical waveguide 16c and an optical waveguide 16d may be positioned in central and lower-central regions of glass pane 14, providing interconnection pathways between electrical integrated circuits in middle rows. Moreover, an optical waveguide 16e may be positioned near a bottom portion of glass pane 14, providing connectivity to a lower row of electrical integrated circuits. Additional optical waveguides 16 are distributed throughout glass pane 14 to enable the any-to-any optical crossbar topology.

In some embodiments, optical waveguides 16a, 16b, 16c, 16d, and 16e are arranged to provide an any-to-any optical crossbar topology enabling direct optical communication between any pair of the plurality of electrical integrated circuits. In an example configuration, optical waveguide 16a conveys optical signals between electrical integrated circuit 30a and electrical integrated circuit 30b. Optical waveguide 16b conveys optical signals between electrical integrated circuit 30a and electrical integrated circuit 30c. Optical waveguide 16c conveys optical signals between electrical integrated circuit 30a and electrical integrated circuit 30d. Optical waveguide 16d conveys optical signals between electrical integrated circuit 30a and electrical integrated circuit 30e. Optical waveguide 16e conveys optical signals between electrical integrated circuit 30a and electrical integrated circuit 30f.

In other embodiments, at least one of optical waveguides 16a, 16b, 16c, 16d, and 16e is configured to convey optical signals between any other two or more of electrical integrated circuits 30, depending on the path of the respective waveguide. The arrangement of optical waveguides enables direct optical communication between any pair of electrical integrated circuits, allowing for constant latency communication regardless of the physical positions of the communicating dies on glass pane 14.

In some embodiments, circuit switching logic embedded within glass pane 14 is configured to dynamically select which of optical waveguides 16a, 16b, 16c, 16d, 16e, or other optical waveguides 16 to use based on a destination of a communication between two or more of the plurality of electrical integrated circuits. Circuit switch 18, as shown and described in detail in Fig. 1 above, functions as the circuit switching logic and dynamically adjusts routing of optical signals during operation to direct communications to appropriate destinations through selected optical waveguides.

In other embodiments, optical waveguides 16 are alternatively arranged to provide an optical ring topology interconnecting the plurality of electrical integrated circuits. In such embodiments, electrical integrated circuits 30a, 30b, 30c, 30d, 30e, and 30f are interconnected in a serial (or combined serial and parallel) communication configuration forming a ring-shaped communication pathway, as described in Fig. 2 above. In some embodiments, circuit switching logic 18 is configured to select between ring topology routing and crossbar topology routing based on communication requirements.

In some embodiments, glass optical interposer assembly 11 further comprises long reach interface chiplets 31 positioned at corners or edges of glass pane 14 to provide connectivity to external systems. The long reach interface chiplets 31 are configured to connect to electrical integrated circuits 30a, 30b, 30c, 30d, 30e, and 30f through optical waveguides 16 embedded within glass pane 14, and provide external communication pathways to components outside of glass optical interposer assembly 11, such as other glass optical interposer assemblies, network interfaces, or storage systems.

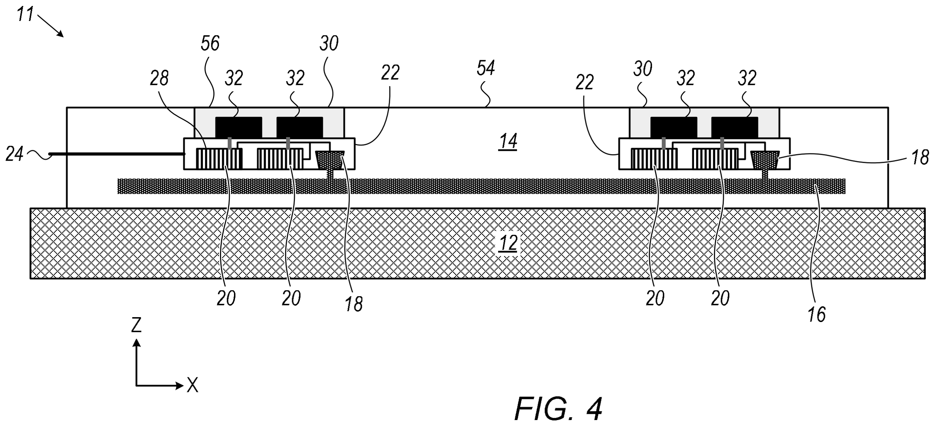

Fig. 4 is a cross-sectional view that schematically illustrates glass optical interposer assembly 11 with embedded components, in accordance with an embodiment that is described herein.

In some embodiments, glass optical interposer assembly 11 comprises PCB 12 serving as a base layer, upon which glass pane 14 is positioned. Glass pane 14 contains optical waveguide 16 embedded within glass pane 14, which extends horizontally through glass pane 14 to provide optical communication pathways between components, as described in detail in Fig. 1 above.

In some embodiments, optical integrated circuits 22, also referred to herein as optical transceiver integrated circuits, are three-dimensionally stacked with respective ones of electrical integrated circuits 30. The three-dimensionally stacked optical integrated circuits 22 and electrical integrated circuits 30 are embedded within glass pane 14. In such embodiments, each optical integrated circuit 22 is positioned, along the Z-axis, beneath a corresponding electrical integrated circuit 30, with the stacked assembly embedded within glass pane 14 rather than mounted on a surface of glass pane 14.

In some embodiments, an outer surface 54 of glass pane 14 and an outer surface 56 of EIC 30, are flush with one another in some configurations. In other configurations, surface 54 covers surface 56 when electrical integrated circuit 30 is fully embedded within glass pane 14. The relationship between surface 54 and surface 56 depends on the depth to which electrical integrated circuit 30 is embedded within glass pane 14.

In some embodiments, the embedded configuration of three-dimensionally stacked optical integrated circuits 22 and electrical integrated circuits 30 reduces insertion loss between the electrical and optical integrated circuits. The reduced insertion loss results from the shortened signal path between electrical integrated circuit 30 and optical integrated circuit 22 when the components are stacked and embedded together within glass pane 14, making the construct more power-efficient compared to configurations in which electrical integrated circuit 30 is mounted on a surface of glass pane 14 with package substrate 26 interposed between electrical integrated circuit 30 and optical integrated circuit 22.

In some embodiments, electrical integrated circuit 30 comprises any suitable type of an Artificial Intelligence (AI) chip accelerator or a Graphical Processing Unit (GPU) that executes sharded AI models distributed across multiple chips. In other embodiments, electrical integrated circuit 30 comprises a High Bandwidth Memory (HBM) with stacked Dynamic Random Access Memory (DRAM) dies, such as a stack of 16 DRAMs. The three-dimensional stacking of optical integrated circuit 22 with electrical integrated circuit 30, and the embedding of the stacked assembly within glass pane 14, enables high-bandwidth optical communication between AI chip accelerators, GPUs, or HBM components with reduced power consumption due to the lower insertion loss.

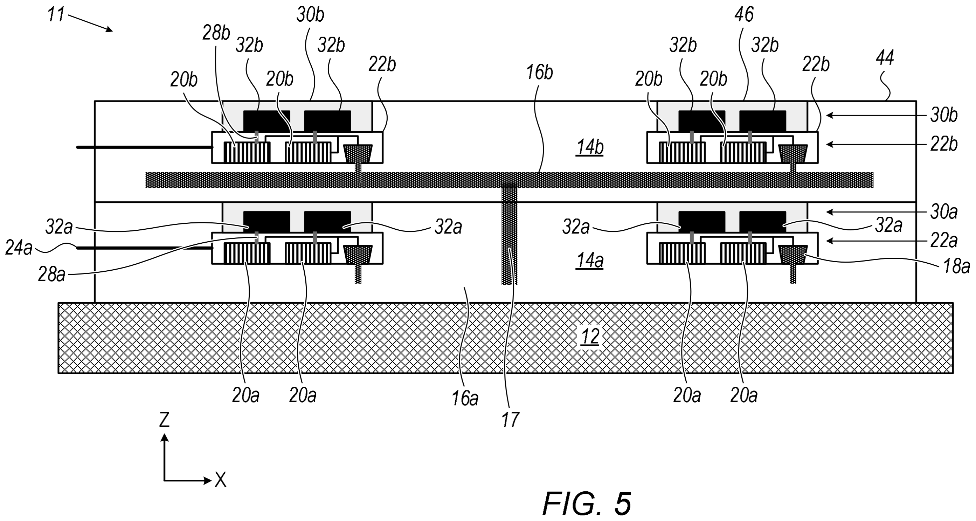

Fig. 5 is a cross-sectional view that schematically illustrates a vertically tiled glass optical interposer assembly 11, in accordance with another embodiment that is described herein.

In some embodiments, glass optical interposer assembly 11 comprises PCB 12 that provides mechanical support and electrical connectivity for a stacked glass pane structure positioned over PCB 12. Glass optical interposer assembly 11 comprises a first glass pane 14a and a second glass pane 14b arranged in a vertically stacked configuration. First glass pane 14a is positioned over PCB 12, and second glass pane 14b is stacked on first glass pane 14a.

In some embodiments, first glass pane 14a comprises an optical waveguide 16a embedded within first glass pane 14a, along with one or more circuit switches 18a for routing optical signals. First glass pane 14a also contains one or more optical integrated circuits (OICs) 22a, also referred to herein as an optical transceiver integrated circuits, each of which comprises one or more optical IOs (OIOs) 20a for converting between electrical and optical signals. A light source 24a is associated with optical integrated circuits 22a to generate optical signals for transmission through optical waveguide 16a. One or more electrical integrated circuits (EICs) 30a are coupled to or embedded in first glass pane 14a and each EIC 30a comprises one or more electrical IOs (EIOs) 32a for electrical signal transmission. One or more electro-optical interfaces 28a are coupled between respective pairs of EIOs 32a and OIOs 20a to facilitate signal communication therebetween.

In some embodiments, second glass pane 14b comprises an optical waveguide 16b embedded within second glass pane 14b, along with one or more circuit switches 18b for routing optical signals. Second glass pane 14b contains one or more optical integrated circuits (OICs) 22b, also referred to herein as optical transceiver integrated circuits. At least one of, and typically each OIC 22b comprises one or more optical IOs (OIOs) 20b. A light source 24b is associated with optical integrated circuits 22b. One or more electrical integrated circuits (EICs) 30b are coupled to or embedded in first glass pane 14a and each EIC 30b comprises one or more electrical IOs (EIOs) 32b for electrical signal transmission. One or more electro-optical interfaces 28b are coupled between respective pairs of EIOs 32b and OIOs 20b to facilitate signal communication therebetween.

In some embodiments, each electrical integrated circuit 30a is three-dimensionally stacked over a respective optical integrated circuit 22a, and each electrical integrated circuit 30b is three-dimensionally stacked over a respective optical integrated circuit 22b. The three-dimensionally stacked optical integrated circuits 22a and 22b and electrical integrated circuits 30a and 30b are embedded within first glass pane 14a and second glass pane 14b, respectively. In such embodiments, optical integrated circuits 22a and 22b function as optical transceiver integrated circuits, and electrical integrated circuits 30a and 30b are embedded within the respective glass panes.

In some embodiments, glass optical interposer assembly 11 comprises one or more vertical waveguides 17, each of which extends between first glass pane 14a and second glass pane 14b to optically interconnect first glass pane 14a and second glass pane 14b. Vertical waveguides 17 enable optical communication between components on different layers of glass optical interposer assembly 11, allowing electrical integrated circuit 30a embedded in first glass pane 14a to communicate optically with electrical integrated circuit 30b embedded in second glass pane 14b through vertical waveguide 17. In some embodiments, glass optical interposer assembly 11 may comprise a single light source 24, for example, light source 24b may be omitted from the configuration of Fig. 5 and light source 24a may supply sufficient light conveyed through the horizontal waveguides 16a and 16b, and through vertical waveguide 17.

In some embodiments, an outer surface 44 of second glass pane 14b and an outer surface 46 of electrical integrated circuits 30b are flush with one another in some configurations. In other configurations, surface 44 covers surface 46 when at least one of electrical integrated circuits 30b is fully embedded within second glass pane 14b. The relationship between surface 44 and surface 46 is as described above with respect to surface 54 and surface 56 in Fig. 4, depending on the depth to which electrical integrated circuit 30b is embedded within second glass pane 14b.

In some embodiments, the vertically tiled configuration of glass optical interposer assembly 11 increases system density without increasing lateral distance between dies. By stacking first glass pane 14a and second glass pane 14b with embedded electrical integrated circuits 30a and 30b, and interconnecting the stacked glass panes through one or more vertical waveguides 17, glass optical interposer assembly 11 enables more compact integration of multiple electrical integrated circuits with optical interconnection capabilities while maintaining the low-latency optical communication pathways provided by optical waveguides 16a and 16b.

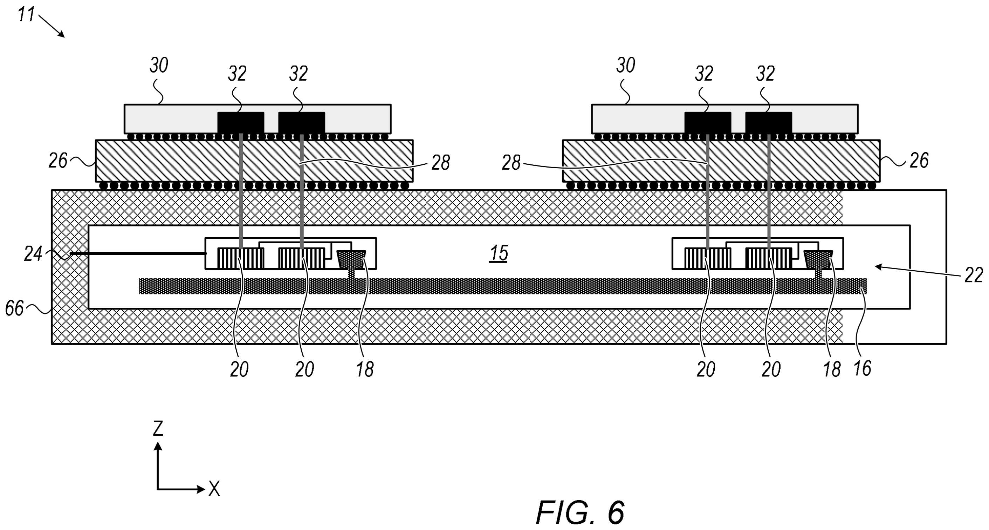

Fig. 6 is a cross-sectional view that schematically illustrates glass optical interposer assembly 11 comprising a PCB 66 with a glass core 15, in accordance with an embodiment that is described herein.

In some embodiments, glass optical interposer assembly 11 comprises PCB 66, in which glass core 15 is integrated as a core layer within PCB 66 rather than mounted on top of a separate printed circuit board, as shown for example in Fig. 1 above. Glass core 15 may be identical to glass pane 14 described in Figs. 1-4 above as well as glass panes 14a and 14b described in Fig. 5 above, or may differ therefrom in dimensions, material composition, or embedded component configuration. The integration of glass core 15 within PCB 66 provides structural support through the stiffness of glass while enabling optical communication pathways to be embedded within the board structure of PCB 66.

In some embodiments, optical waveguide 16 is embedded within glass core 15. Optical waveguide 16 extends horizontally through glass core 15 to provide optical communication pathways between components positioned on one side as well as on opposite sides of PCB 66. Circuit switches 18 are embedded within glass core 15 and coupled to optical waveguide 16 to enable selective routing of optical signals between components. Optical IOs (OIOs) 20 are positioned within glass core 15 to facilitate coupling of optical signals between optical waveguide 16 and optical integrated circuits 22. Optical integrated circuits (OICs) 22, which function as optical transceiver integrated circuits, are embedded within glass core 15. Light source 24 is positioned within glass core 15 to generate optical signals for transmission through optical waveguide 16.

In some embodiments, package substrates 26 are positioned on the outer surface of PCB 66. Each package substrate 26 supports one or more electrical integrated circuits 30 and electrical IOs 32 components that provide electrical connectivity. Electro-optical interfaces 28 are (i) coupled between at least one of, and typically each, electrical IO 32, and optical IOs 20 embedded within glass core 15, and (ii) traverse package substrate 26. In such embodiments, electro-optical interfaces 28 are configured to provide conversion between electrical signals from electrical integrated circuits 30 and optical signals carried by optical waveguide 16.

In some embodiments, optical integrated circuits 22 may utilize micro-ring resonators (MRR) as the optical interface technology for modulating and detecting optical signals. Micro-ring resonators provide wavelength-selective coupling between optical waveguide 16 and optical integrated circuits 22, enabling efficient conversion between electrical and optical domains. In other embodiments, optical integrated circuits 22 may utilize electro-absorption modulators (EAM) as the optical interface technology. Electro-absorption modulators modulate optical signal intensity based on applied electrical signals, providing an alternative approach to electro-optical conversion within optical integrated circuits 22.

In some embodiments, electrical integrated circuits 30 may utilize Universal Chiplet Interconnect Express (UCIe) as the electrical interface technology for communication with electro-optical interfaces 28. UCIe provides a standardized die-to-die interconnect protocol that enables interoperability between electrical integrated circuits 30 from different sources. In other embodiments, electrical integrated circuits 30 may utilize Extra Short Reach (XSR) as the electrical interface technology. XSR provides low-power, high-bandwidth electrical signaling over short distances between electrical integrated circuits 30 and electro-optical interfaces 28, which is suitable for the close proximity of components within glass optical interposer assembly 11.

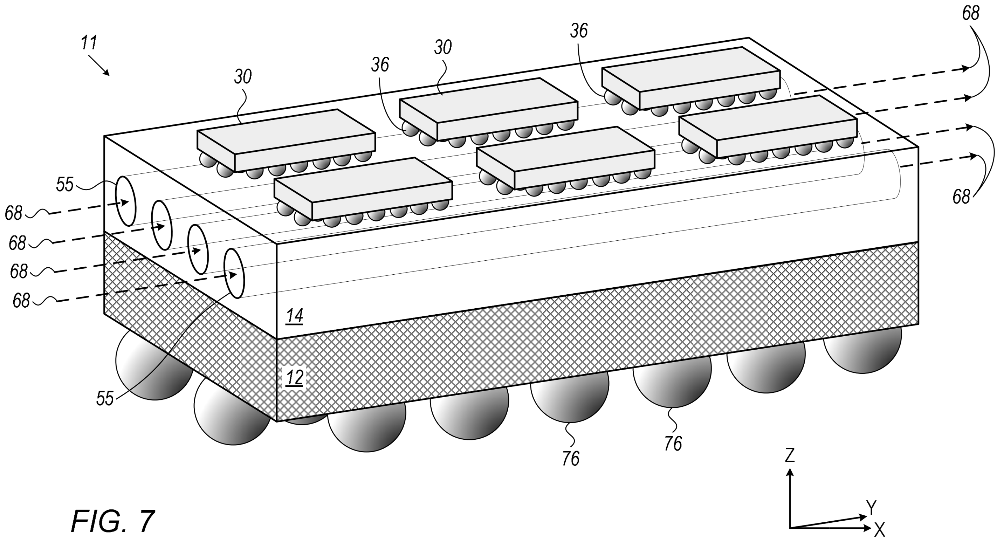

Fig. 7 is an isometric view that schematically illustrates glass optical interposer assembly 11 incorporating micro-cooling channels 55, in accordance with another embodiment that is described herein.

In some embodiments, glass optical interposer assembly 11 comprises PCB 12 positioned beneath glass pane 14, providing mechanical support for the overall structure, as described in detail in Fig. 1 above. Glass pane 14 serves as an optical interposer layer and contains the optical components described for example in Figs. 1-3 above, and optionally the optical components integrated with the electrical components as described in Figs. 4 and 5 above. It is noted that while being operated, at least EICs 30 generate heat that must be dissipated to enable the operation of EICs 30. As shown in the configuration shown for example in Figs. 1 and 6, exposing EICs 30 to external environment, such as air and/or a heat spreader (not shown), may improve the dissipation of the generated heat away from EICs 30. However, in the configurations shown in Figs. 4 and 5, EICs 30, 30a and 30b are embedded within the glass panes 14, 14a and 14b, and the rate of heat dissipation through glass pane 14 is substantially slower. Moreover, the optical components, such as OICs 22, and waveguides 16 and 17 may also be heated by the light introduced by light source 24. In some embodiments, glass pane 14 has a plurality of micro-cooling channels 55 embedded within and passing through glass pane 14. Micro-cooling channels 55 are visible on a front face of glass pane 14 as circular openings with directional arrows indicating flow paths of a fluid 68 (e.g., water or other cooling liquids or gasses) through glass pane 14.

In some embodiments, a plurality of electrical integrated circuits 30 are assembled on the upper surface of glass pane 14 in a distributed arrangement. Each electrical integrated circuit 30 comprises terminals 36 positioned along at least the periphery of electrical integrated circuit 30 for electrical connections to glass pane 14, as described in Fig. 1 above. Terminals 36 enable power and signal distribution between electrical integrated circuits 30 and the optical components embedded within glass pane 14.

In some embodiments, fluid 68 is configured to flow through micro-cooling channels 55 to provide fluid cooling to glass optical interposer assembly 11. Fluid 68 enters micro-cooling channels 55 from one side of glass optical interposer assembly 11 and exits from an opposite side, as indicated by dashed arrows in Fig. 7. In other embodiments, glass pane 14 may have additional openings of micro-cooling channels at other sides thereof (e.g., perpendicular to the sides shown in Fig. 7) so as to increase the rate of heat dissipation. In the configurations described above, the flow of fluid 68 through micro-cooling channels 55 provides a fluid cooling pathway through glass pane 14, enabling heat generated by electrical integrated circuits 30 to be dissipated through the circulating fluid 68.

In some embodiments, PCB 12 is coupled to terminals 76 disposed on a lower surface of PCB 12. Terminals 76 are configured to provide external electrical connections for glass optical interposer assembly 11 to interface with other system components, such as power supplies, external memory systems, or network interfaces. Terminals 76 enable glass optical interposer assembly 11 to be integrated into larger computing systems while maintaining the optical communication pathways and fluid cooling capabilities provided by glass pane 14.

In some embodiments, the plurality of micro-cooling channels 55 embedded within glass pane 14 enable liquid cooling of glass optical interposer assembly 11. The embedding of micro-cooling channels 55 within glass pane 14 takes advantage of real estate within glass pane 14 that would otherwise be unused, positioning the cooling infrastructure in close proximity to electrical integrated circuits 30 that generate heat during operation. This cooling approach addresses thermal management challenges that arise when multiple high-power electrical integrated circuits 30, such as AI chip accelerators or GPUs executing sharded AI models, are assembled on glass pane 14.

In some embodiments, the combination of micro-cooling channels 55 with the embedded optical components described in Figs. 1-6 above enables glass optical interposer assembly 11 to support high-density integration of electrical integrated circuits 30 while maintaining thermal stability. Fluid 68 flowing through micro-cooling channels 55 removes heat from the vicinity of electrical integrated circuits 30, as well as from optical elements such as OICs 22 (shown for example in Figs. 1 and 6 above). The heat dissipation by fluid 68 enables sustained high-performance operation of the distributed computing system formed by the plurality of electrical integrated circuits 30 interconnected through the optical waveguides embedded within glass pane 14.

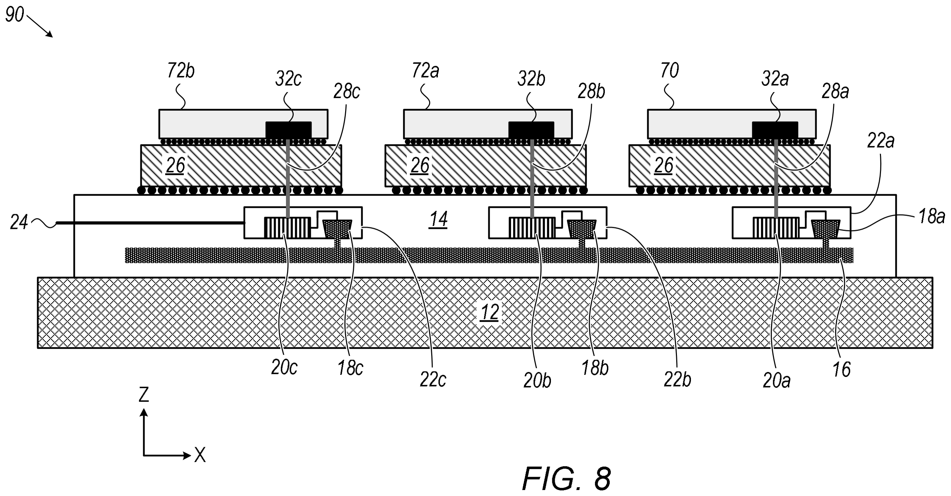

Fig. 8 is a cross-sectional view that schematically illustrates a glass optical interposer assembly 90 comprising a compute dies, such as an application-specific integrated circuit (ASIC) 70 optically interconnected with high bandwidth memory (HBM) 72a and HBM 72b components, in accordance with an embodiment that is described herein.

In some embodiments, glass optical interposer assembly 90 comprises PCB 12 serving as a base layer that provides mechanical support and electrical connectivity, as described in detail in Fig. 1 above. Glass pane 14 is positioned on PCB 12 and contains embedded optical components for communication between the integrated circuits.

In some embodiments, glass pane 14 contains optical waveguide 16 embedded within glass pane 14. Waveguide 16 extends horizontally through glass pane 14 to provide optical communication pathways between the components (e.g., ASIC 70 and HBMs 72a and 72b). Light source 24 is positioned at one end of glass pane 14 and is coupled to optical waveguide 16 to generate optical signals for transmission through the optical communication pathways.

In some embodiments, three optical integrated circuits are embedded within glass pane 14. Optical integrated circuit 22a is positioned beneath ASIC 70, an optical integrated circuit 22b is positioned beneath HBM 72a, and an optical integrated circuit 22c is positioned beneath HBM 72b. In the present example, the term beneath refers to having the ASIC and the HBMs aligned along the Z-axis with the respective optical integrated circuit. In other words, optical integrated circuit 22a, optical integrated circuit 22b, and optical integrated circuit 22c are positioned at respective depths having a z dimension offset relative to ASIC 70, HBM 72a, and HBM 72b, respectively. Each optical integrated circuit functions as an optical transceiver integrated circuit for converting between electrical and optical signals, as described in detail, for example, in Fig. 1 above.

In some embodiments, each optical integrated circuit 22 is associated with corresponding optical IO 20 components and circuit switches. Optical integrated circuit 22a comprises an optical IO 20a and is coupled to a circuit switch 18a. Optical integrated circuit 22b comprises an optical IO 20b and is coupled to a circuit switch 18b. Optical integrated circuit 22c comprises an optical IO 20c and is coupled to a circuit switch 18c. Circuit switches 18a, 18b, and 18c are configured to enable selective routing of optical signals through optical waveguide 16.

In some embodiments, glass optical interposer assembly 90 further comprises three package substrates 26 positioned on glass pane 14. Each package substrate 26 supports a respective integrated circuit component. ASIC 70 is mounted on a first package substrate 26, HBM 72a is mounted on a second package substrate 26, and HBM 72b is mounted on a third package substrate 26. Notably, package substrates 26 may differ from one another, for example, in the pattern and density of electrical leads for routing the signal exchanged with the respective integrated circuit component.

In some embodiments, each of HBM 72a and HBM 72b comprises a three-dimensional stack of memory dies, such as DRAM dies, connected through through-silicon vias (TSVs) to a buffer die. The buffer die contains controller circuitry and an electrical interface for communication with ASIC 70. In some embodiments, the buffer die comprises an electrical interface compatible with an optical engine, such as an Extra Short Reach (XSR) interface or an Ultra High Density Interconnect (UHDI) interface, rather than a conventional HBM physical layer interface. By replacing the conventional HBM physical layer interface with an electrical interface compatible with optical engines, HBM 72a and HBM 72b can communicate with ASIC 70 through the optical communication pathways provided by optical waveguide 16 and optical integrated circuits 22a, 22b, and 22c, rather than through conventional electrical interconnects that are constrained by beachfront limitations.

In some embodiments, electro-optical interfaces are positioned between package substrates 26 and glass pane 14 to facilitate signal conversion. An electro-optical interface 28a is positioned beneath (e.g., at a Z dimension offset and aligned along the Z-axis with) ASIC 70, an electro-optical interface 28b is positioned beneath (e.g., at a Z dimension offset and aligned along the Z-axis with) HBM 72a, and an electro-optical interface 28c is positioned beneath (e.g., at a Z dimension offset and aligned along the Z-axis with) HBM 72b. Each electro-optical interface is configured to provide conversion between electrical signals from the respective integrated circuit and optical signals carried by optical waveguide 16.

In some embodiments, electrical IO components are positioned on the integrated circuits to provide electrical signal interfaces. An electrical IO 32a is positioned on ASIC 70, an electrical IO 32b is positioned on HBM 72a, and an electrical IO 32c is positioned on HBM 72b. The electrical IO components enable communication between the integrated circuits and the electro-optical interfaces.

In some embodiments, the configuration shown in Fig. 8 demonstrates the optical interconnection of ASIC 70 with multiple HBM components, specifically HBM 72a and HBM 72b, through optical waveguide 16 embedded within glass pane 14. This arrangement enables high-bandwidth optical communication between ASIC 70 and the high bandwidth memory components, with circuit switches 18a, 18b, and 18c providing selective routing of optical signals based on communication destinations.

It is noted that conventional HBM implementations face limitations in scaling memory bandwidth and capacity. The number of HBMs that can be positioned around a compute die is constrained by various factors such as beachfront limitations at the die edges, throughput and signal integrity constraints of the electrical interface. Additionally, the number of HBMs is limited due to the inability to maintain performance when HBMs are placed at diagonal positions or greater distances from the compute die. These constraints restrict the ability to add additional rows and columns of HBMs around computing elements, such as ASIC 70, limiting the memory capacity and bandwidth available to high-performance computing systems.

In some embodiments, the disclosed glass optical interposer architecture addresses this problem by enabling optical interconnection between (i) HBMs, such as HBMs 72a and 72b, and (ii) compute dies, such as application-specific integrated circuits (ASIC) 70. By replacing physical layer interfaces of conventional HBMs with electrical interfaces compatible with optical engines, HBMs 72a and 72b and ASIC 70 can be assembled on glass pane 14 and interconnected through embedded optical waveguides 16. This configuration overcomes the beachfront limitations of conventional HBM implementations, allowing electrical interfaces to be positioned anywhere within HBM 72a, HBM 72b and ASIC 70 dies rather than being restricted to die edges.

In some embodiments, the optical interconnection through glass pane 14 enables placement of any number of HBMs 72 around ASIC 70 at varying distances, such as diagonal positions and multiple rows of HBMs 72 that would be infeasible with conventional electrical interconnects. The embedded optical interfaces allow communication over relatively significant distances without loss of performance or noticeable increase in latency, thereby greatly increasing memory capacity, bandwidth, and connectivity available to high-performance computing systems.

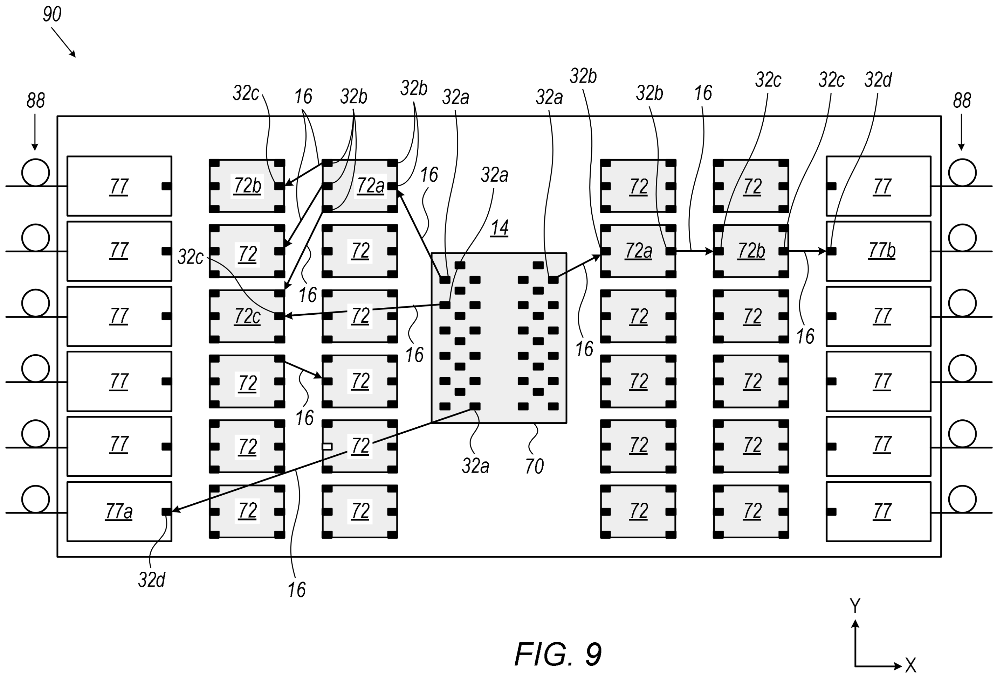

Fig. 9 is a top view that schematically illustrates glass optical interposer assembly 90 configured with a plurality of electrical integrated circuits and optical communication infrastructure described herein, in accordance with an embodiment that is described herein.

In some embodiments, glass optical interposer assembly 90 comprises glass pane 14 that serves as the optical interposer substrate containing embedded optical waveguides and optical communication components, as described in detail in Figs. 1-9 above.

In some embodiments, glass pane 14 supports ASIC 70, which is positioned in a central region of glass pane 14. ASIC 70 is surrounded by a plurality of high bandwidth memory (HBM) components arranged in a distributed pattern across glass pane 14. The HBM components comprise HBM 72a, HBM 72b, HBM 72c, and additional HBM 72 components positioned at various locations on glass pane 14. The HBM components are arranged to provide memory access to ASIC 70 through the optical communication infrastructure embedded within glass pane 14.

In some embodiments, at least one of the HBM components is positioned at a diagonal position relative to ASIC 70. For example, HBM 72c may be positioned at a corner of glass pane 14 such that HBM 72c is diagonally offset from ASIC 70 rather than being aligned along a single horizontal or vertical axis (e.g., parallel to the X-axis or the Y-axis). The optical interconnection through glass pane 14 enables such diagonal positioning without loss of performance or increase in latency, which would be infeasible with conventional electrical interconnects that require HBM components to be positioned adjacent to and aligned with the edges of the compute die.

In some embodiments, glass pane 14 further comprises optical engines 77 positioned along the edges of glass pane 14. Optical engines 77 are configured to provide optical transceiver functionality for converting between electrical and optical signals, as described in the definitions section above. Additional HBM components designated as HBM 77a and HBM 77b are positioned adjacent to optical engines 77 along the edges of glass pane 14.

In some embodiments, glass pane 14 contains optical waveguides 16 embedded within glass pane 14. Optical waveguides 16 are configured to provide optical communication pathways between ASIC 70, the HBM components, and optical engines 77. Optical waveguides 16 are configured to serve as optical D2D (die-to-die) connections enabling communication between the various components assembled on glass pane 14.

In some embodiments, the plurality of HBM components are interconnected among themselves through optical waveguides 16, in addition to being connected to ASIC 70. For example, HBM 72a may communicate directly with HBM 72b through optical waveguide 16 without requiring signals to traverse through ASIC 70. This HBM-to-HBM optical interconnection enables data sharing and coordination between HBM components, which may be beneficial for memory operations that involve data movement between different memory regions.

In some embodiments, electrical IO 32 components are distributed throughout the components coupled to glass pane 14. Electrical IO 32 are connected to optical IOs 20, as shown for example in the sectional view of Fig. 8. Electrical IO 32a are positioned on ASIC 70, and respective optical IOs 20a (not shown in the top view but shown in the sectional view of Fig. 8), are positioned beneath electrical IOs 32a. Electrical IO 32b are positioned on HBMs 72 and HBMs 72a located at the columns in close proximity to ASIC 70, and optical IO 20b (shown in the sectional view of Fig. 8) are positioned beneath these HBMs. In the present context, the terms row and column refer to the arrangement of HBMs along the X-axis and/or along the Y-axis of the coordinate system of Fig. 9. In the present example, the HBMs may be arranged in both columns and rows by adding one or more HBMs 72 above and below ASIC 70 along the Z-axis.

In some embodiments, electrical IO 32c are positioned on HBMs 72 and HBMs 72b located at the columns in close proximity to optical engines 77, and optical IO 20c (shown in the sectional view of Fig. 8) are positioned beneath electrical IOs 32c. Optical engines 77, 77a and 77b exchange signals with ASIC 70 and the HBMs. For example, electrical IOs 32d that are positioned on optical engines 77a and 77b are configured to exchange electrical signals with ASIC 70 and HBM 72b, respectively. Electrical IO components 32a, 32b, 32c, and 32d and the respective optical IO components 20a, 20b, 20c and the optical IO 20 connected to electrical IO 32d, provide electrical signal interfaces for communication between the electrical integrated circuits and the optical communication infrastructure.

In some embodiments, optical waveguide 16 provides a direct optical communication pathway between electrical IO 32a of ASIC 70 and electrical IO 32d of optical engine 77a. This optical pathway enables ASIC 70 to communicate with external systems through optical engine 77a, with optical signals transmitted through optical waveguide 16 and converted between electrical and optical domains by the respective optical transceiver integrated circuits positioned beneath ASIC 70 and optical engine 77a.

In some embodiments, optical waveguide 16 provides a direct optical communication pathway between electrical IO 32a of ASIC 70 and electrical IO 32c of HBM 72b of glass pane 14, which is positioned within a column relatively remote from ASIC 70. This optical pathway enables ASIC 70 to communicate directly with HBM 72b regardless of the physical distance between them on glass pane 14. The optical interconnection through optical waveguide 16 enables ASIC 70 to communicate with HBM 72b at the same latency and bandwidth as with HBM components positioned in closer proximity to ASIC 70, such as HBM 72a. This capability overcomes the distance limitations of conventional electrical interconnects, which would suffer from signal degradation and increased latency when communicating with HBM components positioned at greater distances from the compute die.

In some embodiments, the disclosed glass optical interposer architecture enables optical interconnection between high bandwidth memory (HBM) components and compute dies such as application-specific integrated circuits (ASICs). By replacing conventional HBM physical layer interfaces with electrical interfaces compatible with optical engines, HBMs and compute dies can be assembled on glass pane 14 and interconnected through embedded optical waveguides 16. This configuration overcomes the beachfront limitations of conventional HBM implementations, allowing electrical interfaces to be positioned anywhere within HBM 72, HBM 72a, HBM 72b, HBM 72c and ASIC 70 dies rather than being restricted to die edges.

In some embodiments, the optical interconnection through glass pane 14 enables placement of any number of HBMs 72 around ASIC 70 at varying distances, such as diagonal positions and multiple rows of HBMs 72 that would be infeasible with conventional electrical interconnects. In some embodiments, the embedded optical interfaces allow communication over various distances across glass pane 14 without loss of performance or noticeable increase in latency, thereby greatly increasing memory capacity, bandwidth, and connectivity available to high-performance computing systems.

In some embodiments, optical connections 88 are shown at the edges of glass pane 14, representing the optical communication pathways that enable data transfer between glass optical interposer assembly 90 and external entities. The configuration of Fig. 9 enables optical communication between ASIC 70 and the surrounding HBM components through optical waveguides 16, providing high-bandwidth, low-latency data transfer pathways across glass optical interposer assembly 90.

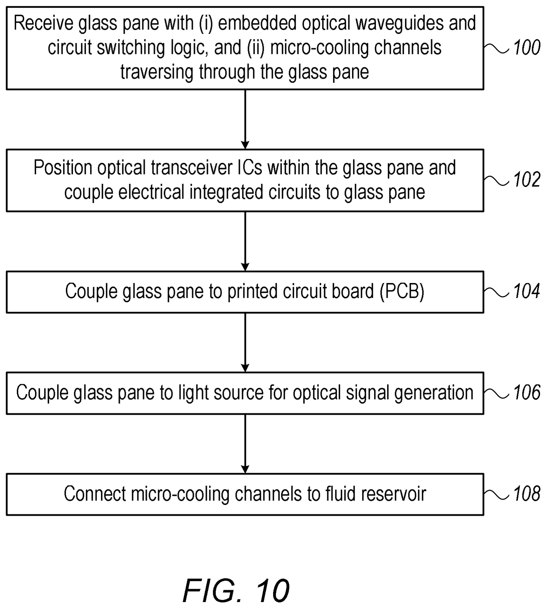

Fig. 10 is a flowchart that schematically illustrates a method of fabricating glass optical interposer assembly 11 shown in the example configurations of Figs. 1 and 7, in accordance with an embodiment that is described herein.

The method begins at a glass pane receiving step 100, with receiving glass pane 14 having (i) one or more optical waveguides 16 and circuit switching logic 18 embedded within glass pane 14, and (ii) a plurality of optical transceiver integrated circuits 22 positioned within glass pane 14. In other embodiments, the method comprises positioning the plurality of optical transceiver integrated circuits 22 positioned within glass pane 14 (rather than receiving them with glass pane 14.

In some embodiments, glass pane 14 further comprises micro-cooling channels 55 traversing through glass pane 14. Micro-cooling channels 55 are optional and may be omitted from the configuration in some embodiments. Glass pane 14, optical waveguides 16, circuit switching logic 18, optical transceiver integrated circuits 22, and micro-cooling channels 55 are as described in detail, for example, in Figs. 1 and 7 above.

At a device coupling step 102, a plurality of individually packaged electrical integrated circuits 30 are coupled to glass pane 14. In some embodiments, electrical integrated circuits 30 are coupled to an outer surface of glass pane 14, with each electrical integrated circuit 30 mounted on a respective package substrate 26, as described in detail, for example, in Figs. 1-3 and 7 above.

In other embodiments, electrical integrated circuits 30 are embedded within glass pane 14, with each electrical integrated circuit 30 three-dimensionally stacked over a respective optical transceiver integrated circuit 22, as described in detail, for example, in Figs. 4 and 5 above. In embodiments comprising vertically tiled glass panes, such as glass pane 14a and glass pane 14b described in Fig. 5 above, electrical integrated circuits 30 are coupled to or embedded within each of the stacked glass panes, and one or more vertical waveguides 17 are formed to optically connect between waveguides 16a and waveguides 16b of glass pane 14a and glass pane 14b, respectively.

At a glass pane coupling step 104, glass pane 14 is coupled to a printed circuit board (PCB) 12. In some embodiments, glass pane 14 is mounted on an outer surface of PCB 12, as described in detail, for example, in Figs. 1 and 7 above. In other embodiments, glass pane 14 is integrated as a core layer within PCB 66, as described in detail in Fig. 6 above.

At a light source coupling step 106, one or more light sources 24 are coupled to one or more glass panes 14, respectively, for generating optical signals for transmission through optical waveguides 16. Light sources 24 generate light that is encoded to optical signals, based on the electrical signals received from the electrical integrated circuits 30. These optical signals are conveyed through optical communication pathways between electrical integrated circuits 30 through optical waveguides 16 and optical transceiver integrated circuits 22, as described in detail, for example, in Figs. 1, 4, 5, and 6 above. In embodiments comprising vertically tiled glass panes, light source 24a and light source 24b are coupled to glass pane 14a and glass pane 14b, respectively, as described in detail in Fig. 5 above.

In some embodiments, the method is applied to fabricate glass optical interposer assembly 90 as described in Figs. 8 and 9 above. In such embodiments, coupling the plurality of individually packaged electrical integrated circuits to glass pane 14 comprises coupling ASIC 70 and a plurality of HBM components, such as HBM 72a, HBM 72b, and HBM 72c, to glass pane 14. Each of ASIC 70 and the HBM components is mounted on a respective package substrate 26 and positioned over a corresponding optical integrated circuit 22a, 22b, or 22c embedded within glass pane 14. In some embodiments, the method further comprises positioning optical engines 77 along the edges of glass pane 14 to provide external connectivity to systems outside glass optical interposer assembly 90. Additional HBM components, such as HBM 77a and HBM 77b, may be positioned adjacent to optical engines 77 along the edges of glass pane 14.

In some embodiments, the method further comprises positioning at least one of the HBM components at a diagonal position relative to ASIC 70. For example, HBM 72c may be positioned at a corner of glass pane 14 such that HBM 72c is diagonally offset from ASIC 70 rather than being aligned along a single horizontal or vertical axis. In some embodiments, the method further comprises arranging the plurality of HBM components in multiple rows around ASIC 70, as shown in Fig. 9 above. This configuration enables increased memory capacity beyond what is achievable with a single row of HBM components (e.g., HBMs 72 and 72a) adjacent to the compute die (e.g., ASIC 70).

In some embodiments, the optical interconnection through glass pane 14 enables placement of any number of HBM 72 dies around ASIC 70 at varying distances, for example in diagonal positions and multiple rows of HBM 72 dies. By replacing conventional HBM physical layer interfaces with electrical interfaces compatible with optical engines, the method overcomes beachfront limitations of conventional HBM implementations, allowing electrical interfaces to be positioned anywhere within HBM 72a, HBM 72b, HBM 72c and ASIC 70 dies rather than being restricted to die edges.

In some embodiments, establishing optical communication pathways comprises configuring circuit switching logic 18 to provide an optical ring topology or a grid topology interconnecting electrical integrated circuits 30 in a serial communication configuration, as described in detail in Fig. 2 above. In other embodiments, establishing optical communication pathways comprises configuring circuit switching logic 18 to provide an any-to-any optical crossbar topology enabling direct optical communication between any pair of electrical integrated circuits 30, as described in detail in Fig. 3 above. In such embodiments, circuit switch 18 functions as the circuit switching logic and is configured to route optical signals through optical waveguides 16 to enable direct communication between any pair of electrical integrated circuits 30 without requiring signals to traverse intermediate nodes.

In some embodiments, the method further comprises dynamically adjusting circuit switching logic 18 to select which of optical waveguides 16 to use based on a destination of a communication. Circuit switch 18 dynamically selects which of optical waveguides 16, 16a, 16b, 16c, 16d, or 16e to use based on the destination of a communication between two or more of electrical integrated circuits 30, as described in detail, for example, in Figs. 1 and 3 above.

At a fluid connecting step 108 that concludes the method, micro-cooling channels 55 are coupled to a fluid reservoir for improving heat dissipation by flowing fluid 68 through micro-cooling channels 55. Fluid 68 enters micro-cooling channels 55 from one side of glas pane 14 of glass optical interposer assembly 11 and exits from an opposite side to provide fluid cooling to electrical integrated circuits 30, as described in detail in Fig. 7 above. In some embodiments, the method further comprises forming micro-cooling channels 55 within glass pane 14 to provide fluid cooling to electrical integrated circuits 30. In alternative embodiments, because micro-cooling channels 55 are optional, connecting step 108 may be omitted from the method in the absence of micro-cooling channels 55 from the configuration.

The configurations of glass optical interposer assemblies 11 and 90 and their components, as illustrated in Figs. 1-9, are example configurations chosen purely for the sake of conceptual clarity. In alternative embodiments, any other suitable configuration can be used.

In some embodiments, EIC 30, EIC 30a and EIC 30b and their respective components, e.g., electrical IOs 32, IOs 32a and IOs 32b, may be implemented using suitable hardware, such as in one or more Application-Specific Integrated Circuits (ASICs) or Field-Programmable Gate Arrays (FPGAs), using software, or using a combination of hardware and software elements. Elements that are not mandatory for understanding of the disclosed techniques have been omitted from the figure for the sake of clarity.

In some embodiments, certain functions of EIC 30 and/or ASIC 70 may be implemented in a general-purpose processor, which is programmed in software to carry out the functions described herein. The software may be downloaded to the processor in electronic form, over a network, for example, or it may, alternatively or additionally, be provided and/or stored on non-transitory tangible media, such as magnetic, optical, or electronic memory.

Although the embodiments described herein mainly address methods and systems for enhancing die-to-die communication using optical interconnect architectures such as glass-based optical interposers, the methods and systems described herein can also be used in other applications.

It is noted that the embodiments described above are cited by way of example, and that the present invention is not limited to what has been particularly shown and described hereinabove. Rather, the scope of the present invention includes both combinations and sub-combinations of the various features described hereinabove, as well as variations and modifications thereof which would occur to persons skilled in the art upon reading the foregoing description and which are not disclosed in the prior art. Documents incorporated by reference in the present patent application are to be considered an integral part of the application except that to the extent any terms are defined in these incorporated documents in a manner that conflicts with the definitions made explicitly or implicitly in the present specification, only the definitions in the present specification should be considered.

### THE FOLLOWING IS A LIST OF FURTHER PREFERRED EMBODIMENTS OF THE INVENTION:

1. A glass optical interposer assembly (11, 90), comprising:
   a glass pane (14) having one or more optical waveguides (16) embedded therein;
   a compute die (70) coupled to the glass pane (14);
   a plurality of high bandwidth memory (HBM) components (72) coupled to the glass pane (14) and arranged around the compute die (70); and
   a plurality of optical transceiver integrated circuits (22) embedded within the glass pane (14) and positioned at a depth having a Z dimension offset relative to respective ones of the compute die (70) and the plurality of HBM components (72),
   wherein the one or more optical waveguides (16) provide optical communication pathways between the compute die (70) and the plurality of HBM components (72) through the plurality of optical transceiver integrated circuits (22).
2. The glass optical interposer assembly according to embodiment 1, wherein the compute die comprises an application-specific integrated circuit (ASIC) (70).
3. The glass optical interposer assembly according to embodiment 1, wherein at least one of the plurality of HBM components is positioned at a diagonal position relative to the compute die.
4. The glass optical interposer assembly according to embodiment 1, wherein the plurality of HBM components are arranged in multiple rows around the compute die.
5. The glass optical interposer assembly according to any of embodiments 1-4, wherein each of the plurality of HBM components comprises a three-dimensional stack of memory dies connected through through-silicon vias to a buffer die.
6. The glass optical interposer assembly according to embodiment 5, wherein the buffer die comprises an electrical interface compatible with an optical engine (77).
7. The glass optical interposer assembly according to any of embodiments 1-4, further comprising one or more optical engines (77) positioned along edges of the glass pane to provide external connectivity to systems outside the glass optical interposer assembly.
8. The glass optical interposer assembly according to embodiment 7, further comprising additional HBM components positioned adjacent to the one or more optical engines along the edges of the glass pane, the additional HBM components are configured to exchange signals with the compute die through the one or more optical waveguides.
9. The glass optical interposer assembly according to embodiment 7, wherein the one or more optical waveguides and the one or more optical engines are configured to provide optical communication pathways between the plurality of HBM components and external optical engines.
10. The glass optical interposer assembly according to any of embodiments 1-4, wherein electrical interfaces of the compute die and the plurality of HBM components are positioned within interior regions of the respective dies and are not restricted to die edges.
11. The glass optical interposer assembly according to any of embodiments 1-4, further comprising circuit switching logic (18) embedded within the glass pane and coupled to the one or more optical waveguides, wherein the circuit switching logic is configured to selectively route optical signals between the compute die and the plurality of HBM components.
12. The glass optical interposer assembly according to any of embodiments 1-4, wherein the one or more optical waveguides are configured to provide constant latency optical communication pathways between the compute die and any of the plurality of HBM components regardless of physical positions of the HBM components on the glass pane.
13. The glass optical interposer assembly according to any of embodiments 1-4, wherein (i) a first HBM component and (ii) a second HBM component, among the plurality of HBM components, are interconnected through the one or more optical waveguides.
14. The glass optical interposer assembly according to any of embodiments 1-4, further comprising a printed circuit board (12, 66) configured to exchange signals with the glass pane, wherein the glass pane is positioned on the printed circuit board.
15. The glass optical interposer assembly according to any of embodiments 1-4, wherein the one or more optical waveguides are configured to provide optical communication pathways between the compute die, the plurality of HBM components, and one or more optical engines, enabling communication with external systems.
16. A method for fabricating a glass optical interposer assembly (11, 90), the method comprising:
   receiving a glass pane (14) having one or more optical waveguides (16) and a plurality of optical transceiver integrated circuits (22) embedded therein;
   coupling a compute die (70) to the glass pane (14);
   coupling a plurality of high bandwidth memory (HBM) components (72) to the glass pane (14), the plurality of HBM components arranged around the compute die (70); and
   establishing optical communication pathways between the compute die (70) and the plurality of HBM components (72) through the one or more optical waveguides (16) and the plurality of optical transceiver integrated circuits (22).
17. The method according to embodiment 16, further comprising positioning at least one of the plurality of HBM components at a diagonal position relative to the compute die.
18. The method according to embodiment 16, further comprising arranging the plurality of HBM components in multiple rows around the compute die.
19. The method according to any of embodiments 16-18, further comprising positioning one or more optical engines (76) along edges of the glass pane to provide external connectivity to systems outside the glass optical interposer assembly.
20. The method according to any of embodiments 16-18, wherein coupling the plurality of HBM components comprises replacing a physical layer interface of an HBM with an electrical interface compatible with an optical engine (77).

## Claims

1. A glass optical interposer assembly (11, 90), comprising:
a glass pane (14) having one or more optical waveguides (16) embedded therein;
a compute die (70) coupled to the glass pane (14);
a plurality of high bandwidth memory (HBM) components (72) coupled to the glass pane (14) and arranged around the compute die (70); and
a plurality of optical transceiver integrated circuits (22) embedded within the glass pane (14) and positioned at a depth having a Z dimension offset relative to respective ones of the compute die (70) and the plurality of HBM components (72),
wherein the one or more optical waveguides (16) provide optical communication pathways between the compute die (70) and the plurality of HBM components (72) through the plurality of optical transceiver integrated circuits (22).

2. The glass optical interposer assembly according to claim 1, wherein the compute die comprises an application-specific integrated circuit (ASIC) (70).

3. The glass optical interposer assembly according to claim 1, wherein at least one of the plurality of HBM components is positioned at a diagonal position relative to the compute die.

4. The glass optical interposer assembly according to claim 1, wherein the plurality of HBM components are arranged in multiple rows around the compute die.

5. The glass optical interposer assembly according to any of claims 1-4, wherein each of the plurality of HBM components comprises a three-dimensional stack of memory dies connected through through-silicon vias to a buffer die.

6. The glass optical interposer assembly according to claim 5, wherein the buffer die comprises an electrical interface compatible with an optical engine (77).

7. The glass optical interposer assembly according to any of claims 1-4, further comprising one or more optical engines (77) positioned along edges of the glass pane to provide external connectivity to systems outside the glass optical interposer assembly.

8. The glass optical interposer assembly according to claim 7, further comprising additional HBM components positioned adjacent to the one or more optical engines along the edges of the glass pane, the additional HBM components are configured to exchange signals with the compute die through the one or more optical waveguides.

9. The glass optical interposer assembly according to claim 7, wherein the one or more optical waveguides and the one or more optical engines are configured to provide optical communication pathways between the plurality of HBM components and external optical engines.

10. The glass optical interposer assembly according to any of claims 1-4, wherein electrical interfaces of the compute die and the plurality of HBM components are positioned within interior regions of the respective dies and are not restricted to die edges, or further comprising circuit switching logic (18) embedded within the glass pane and coupled to the one or more optical waveguides, wherein the circuit switching logic is configured to selectively route optical signals between the compute die and the plurality of HBM components.

11. The glass optical interposer assembly according to any of claims 1-4, wherein the one or more optical waveguides are configured to provide constant latency optical communication pathways between the compute die and any of the plurality of HBM components regardless of physical positions of the HBM components on the glass pane.

12. The glass optical interposer assembly according to any of claims 1-4, wherein (i) a first HBM component and (ii) a second HBM component, among the plurality of HBM components, are interconnected through the one or more optical waveguides, or further comprising a printed circuit board (12, 66) configured to exchange signals with the glass pane, wherein the glass pane is positioned on the printed circuit board, or wherein the one or more optical waveguides are configured to provide optical communication pathways between the compute die, the plurality of HBM components, and one or more optical engines, enabling communication with external systems.

13. A method for fabricating a glass optical interposer assembly (11, 90), the method comprising:
receiving a glass pane (14) having one or more optical waveguides (16) and a plurality of optical transceiver integrated circuits (22) embedded therein;
coupling a compute die (70) to the glass pane (14);
coupling a plurality of high bandwidth memory (HBM) components (72) to the glass pane (14), the plurality of HBM components arranged around the compute die (70); and
establishing optical communication pathways between the compute die (70) and the plurality of HBM components (72) through the one or more optical waveguides (16) and the plurality of optical transceiver integrated circuits (22) .

14. The method according to claim 13, further comprising positioning at least one of the plurality of HBM components at a diagonal position relative to the compute die, or further comprising arranging the plurality of HBM components in multiple rows around the compute die.

15. The method according to any of claims 13-14, further comprising positioning one or more optical engines (76) along edges of the glass pane to provide external connectivity to systems outside the glass optical interposer assembly, or wherein coupling the plurality of HBM components comprises replacing a physical layer interface of an HBM with an electrical interface compatible with an optical engine (77).
